# EUROPEAN PATENT APPLICATION

(11) **EP 4 729 891 A1**
(43) Date of publication of application: **22.04.2026**
(21) Application number: 25207454.7
(22) Date of filing: 08.10.2025
(51) Int. Cl.: G01D 3/08, G01D 21/00, G01D 3/02

(54) **ANALOG SENSOR AND ANALOG SENSOR SYSTEM**

(30) Priority: 17.10.2024 JP 2024182041
(71) Applicant: Yokogawa Electric Corporation, Musashino-shi, Tokyo 180-8750 (JP)
(72) Inventor: KATO, Makoto, Musashino-shi, Tokyo 180-8750 (JP)
(74) Representative: Winter, Brandl - Partnerschaft mbB

(57) **Abstract**

In an analog sensor (100) that is connected to a converter (200) that computes a measured value includes a sensor unit (130) that measures a physical quantity and that converts the physical quantity into an electric signal that is used to compute the measured value, a memory (120) that stores individual information that is information unique to the analog sensor (100),a first signal line (150) that is used to input and output the individual information between the converter (200) and the analog sensor (100), and a second signal line (140) that is used to input and output the electric signal between the converter (200) and the analog sensor (100).

## Description

### FIELD

The present disclosure relates to an analog sensor and an analog sensor system.

### BACKGROUND

A conventional sensor device, such as an analyzer or a filed device that measures various types of physical quantities for industrial processes, includes an analog sensor and a converter. The analog sensor is a detector that converts a measured physical quantity into an electric signal. The analog sensor transmits and receives necessary electric signals to and from the converter. The converter computes a measured value from a received electric signal and transmits the measured value to an upper host.

A conventional exchanger stores individual information, such as identification information and a correction value on a connected analog sensor, and executes a process, such as computing a measured value from an electric signal, using the individual information. Thus, it is assumed that an analog sensor and a converter are used in a fixed pair (see, for example, U.S. Patent No. 2007/0110620).

When an analog sensor is detached from a converter, a correction, or the like, is made, and then the analog sensor is re-connected, however, inconsistency with former individual information stored in the converter occurs. For this reason, a user, or the like, has to do an operation, such as a correction operation on the analog sensor, in a state where the analog sensor is kept connected to the same converter, which is a heavy work.

The disclosure was made in view of the above-described circumstances and an object of the disclosure is to provide an analog sensor that is highly useful.

### SUMMARY

According to an aspect of the embodiments, an analog sensor that is connected to a converter that computes a measured value, the analog sensor includes a sensor unit that measures a physical quantity and that converts the physical quantity into an electric signal that is used to compute the measured value, a memory that stores individual information that is information unique to the analog sensor, a first signal line that is used to input and output the individual information between the converter and the analog sensor, and a second signal line that is used to input and output the electric signal between the converter and the analog sensor.

According to an aspect of the embodiments, an analog sensor system including a converter and an analog sensor, wherein the converter includes an arithmetic section that computes a measured value using an electric signal of the analog sensor, and the analog sensor includes a sensor unit that measures a physical quantity and that converts the physical quantity into an electric signal that is used to compute the measured value, a memory that stores individual information that is information unique to the analog sensor, a first signal line that is used to input and output the individual information between the converter and the analog sensor, and the second signal line that is used to input and output the electric signal between the converter and the analog sensor.

### BRIEF DESCRIPTION OF THE DRAWINGS

FIG. 1 is a diagram illustrating an example of a mode of use of an analog sensor and a converter according to a first embodiment;
FIG. 2 is a diagram illustrating an overview of a conventional analog sensor system using an analog sensor and a converter;
FIG. 3 is a diagram illustrating an example of a configuration of an analog sensor system using the analog sensor and the converter according to the first embodiment;
FIG. 4 is a flowchart illustrating a flow of a process performed by the converter according to the first embodiment;
FIG. 5 is a diagram illustrating an example of a configuration of an analog sensor system using an analog sensor and a converter according to a second embodiment;
FIG. 6 is a diagram illustrating an example of a configuration of an analog sensor system using an analog sensor and a converter according to a third embodiment; and
FIG. 7 is a diagram illustrating an example of a configuration of an analog sensor system using an analog sensor and a converter according to a fourth embodiment.

### DETAILED DESCRIPTION OF THE PREFERRED EMBODIMENTS

Embodiments of an analog sensor and an analog sensor system of the present disclosure will be described in detail below with reference to the accompanying drawings. Note that the embodiments do not limit the disclosure. The same elements are denoted with the same reference numerals and redundant description thereof will be omitted as appropriate. Each of the embodiments may be combined appropriately to the extent without inconsistency.

### First Embodiment

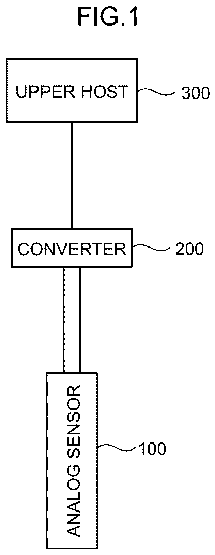

FIG. 1 is a diagram illustrating an example of a mode of use of an analog sensor 100 and a converter 200 of the disclosure. As illustrated in FIG. 1, the analog sensor 100 is connected to the converter 200 using a signal line for transmitting and receiving individual information, such as an identification number of the analog sensor 100, and a signal line for transmitting and receiving an electric signal. The converter 200 computes a measured value based on the individual information, or the like, and the electric signal, further converts the measured value into an analog signal of 4 to 20 mA, or the like, or digital communication of Modbus RTU, or the like, and transmits the signal to an upper host 300, such as a control device. Note that the analog sensor 100 is, for example, a liquid analyzer, such as a pH sensor, that is an analog sensor of a process device or a gas analyzer, such as a zirconia oxygen analyzer.

Before an analog sensor system of the disclosure is described, first of all, an overview and a problem of a system using an analog sensor 20 that is used widely will be described.

### About System using Analog Sensor 20

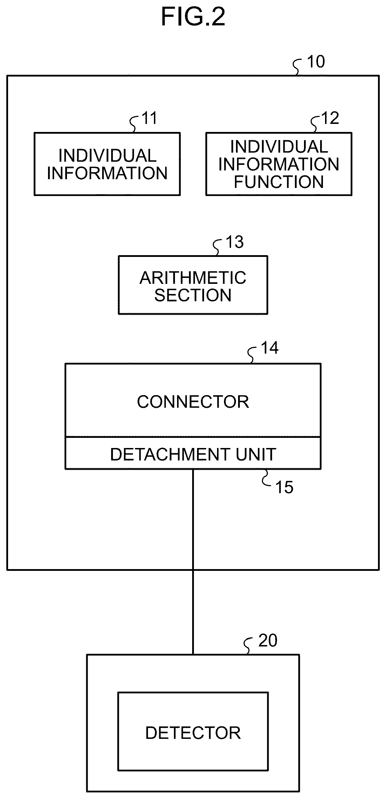

FIG. 2 is a diagram illustrating an overview of a system using the analog sensor 20. As illustrated in FIG. 2, the system using the analog sensor 20 includes the analog sensor 20 including a detector that measures various types of physical quantities and a converter 10 and the analog sensor 20 and the converter 10 are separated from each other. The analog sensor 20 and the converter 10 are configured by being connected with an analog signal line via a connector 14 and a detachment unit 15.

The system using the analog sensor 20 converts the physical quantity that is measured by the detector into an electric signal of an electric current or a voltage and transmits the electric signal to the converter 10 via an analog communication line. The converter 10 acquires the electric signal of the analog signal line from the connector 14. An arithmetic section 13 computes a measured value from the electric signal. Individual information function 12 reads a correction value that is contained in individual information 11 and corrects the measured value using the correction value. The individual information function 12 analyzes a deterioration diagnosis on the analog sensor 20 contained in the individual information 11 and predicts timing of maintenance.

As described above, not the analog sensor 20 but the converter 10 is in charge of storage of the correction value. For this reason, it is assumed that the analog sensor 20 is connected to the converter 10 and then performs measurement.

### About Problem

In such a system using the analog sensor 20, when the analog sensor 20 is attached to another converter 10 or is re-attached to the converter 10, inconsistency with former individual information on the analog sensor 20 that is stored in the converter 10 occurs. For this reason, once the analog sensor 20 is detached from the converter 10, a user has to reset the individual information in the converter 10. The user thus has to perform a correction operation or make a diagnosis for preventive maintenance on the analog sensor 20 in a state where the analog sensor 20 is kept connected to the converter 10.

The converter 10 is a stationary device housed in a robust casing. For this reason, the user has to go to a site of measurement and perform a correction operation, or the like. In general, however, the site of measurement on a process device is often outdoor, a scaffold, or the like, with low workability and working particularly in a bad weather or at night is a hard work to users.

When a spare analog sensor 20 is attached to the converter 10 temporarily in order to deal with a failure of the analog sensor 20 that occurs unexpectedly, the user has to perform an operation, such as a re-correction, on a site of measurement, which is cumbersome. The user is able to transfer the individual information, such as a correction value, to the converter 10 manually; however, a mix-up caused by a human error, or the like, occurs.

In order to assuredly manage the individual information on the analog sensor 20 over a life cycle, the user has to introduce another system in addition to the converter 10 and the another system accumulates and saves individual information in association with a serial number of the analog sensor 20.

As described above, the analog sensor 20 and the converter 10 have a limitation that the analog sensor 20 and the converter 10 are used in a fixed pair, which is not convenient.

### Overview of Analog Sensor System

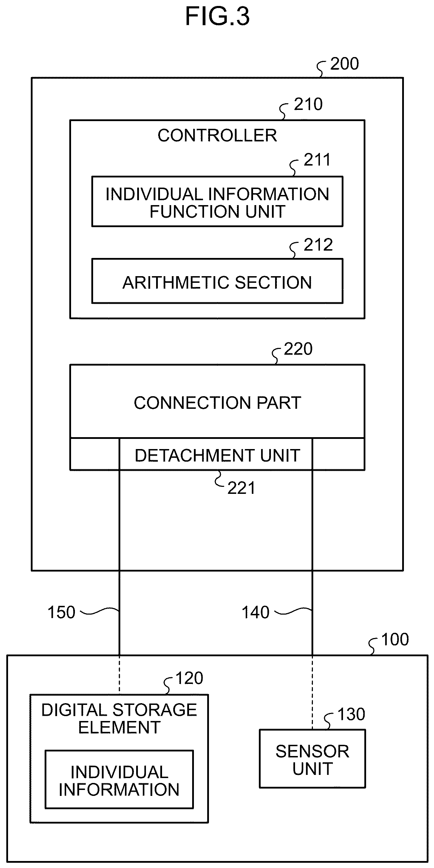

An overview of an analog sensor system according to the disclosure will be described. FIG. 3 is a diagram illustrating an example of a configuration of an analog sensor system using the analog sensor 100 and the converter 200 according to the first embodiment. As illustrated in FIG. 3, the analog sensor system according to the first embodiment includes the converter 200 and the analog sensor 100. The converter 200 and the analog sensor 100 are connected with an analog signal line 140 and an individual information communication line 150.

The converter 200 includes a controller 210 and a connection part 220. The analog sensor 100 includes a digital storage element 120, a sensor unit 130, an analog signal line 140, and the individual information communication line 150. The digital storage element 120 is covered by a memory of the disclosure. The individual information communication line 150 is covered by a first signal line of the disclosure. The analog signal line 140 is covered by a second signal line of the disclosure.

### Configuration

Configurations of the analog sensor 100 and the converter 200 will be described subsequently.

### About Analog Sensor 100

The analog sensor 100 includes the digital storage element 120, the sensor unit 130, the analog signal line 140, and the individual information communication line 150.

The digital storage element 120 records digital information. The digital storage element 120 is, for example, a serial communication EEPROM (trademark) (Electrically Erasable Programmable Read-Only Memory).

For example, the digital storage element 120 stores individual information on the analog sensor 100. The individual information contains a correction value, a correction history, deterioration diagnosis information, a serial number, etc.

The correction value is a value for correcting a measured value that is used to compute a measured value. For example, in some analog sensors 100, the sensor unit 130 necessarily deteriorates over time in principle like a pH meter of a liquid analyzer. The user thus has to perform regular correction operations and cause each analog sensor 100 to store a correction value of each analog sensor 100 as individual information.

The correction history is history data of correction values in the past obtained by making corrections on the analog sensor 100. For example, the analog sensor 100 stores a history of correction values because the degree of deterioration over time changes depending on the environment in which the analog sensor 100 is used and the history is utilized for deterioration diagnosis, and the like.

The deterioration diagnosis information is information on the result of performing deterioration diagnosis based on the correction history. For example, the deterioration diagnosis information is utilized to analyze deterioration diagnosis information and predict the next maintenance timing. The serial number is a product serial number assigned to the analog sensor in manufacturing.

The sensor unit 130 is an analog circuit for converting a physical quantity to be measured into an electric signal. The electric signal converted by the sensor unit 130 is transmitted to the converter 200 via the analog signal line 140.

The analog signal line 140 is connected to the sensor unit 130 of the analog sensor 100 and a detachment unit 221 of the converter 200 and transmits an electric signal necessary to calculate a measured value. The analog signal line 140 is a signal line conforming with electric signals of the sensor unit 130. The dotted-line part of the analog signal line 140 in the analog sensor 100 illustrated in FIG. 3 is any electric wiring in the analog sensor 100 and is, for example, a circuit pattern.

The individual information communication line 150 is connected to the digital storage element 120 of the analog sensor 100 and the detachment unit 221 of the converter 200 and transmits individual information. The individual information communication line 150 is a communication line conforming with the digital storage element 120. The dotted-line part of the individual information communication line 150 in the analog sensor 100 illustrated in FIG. 3 is any electric wiring in the analog sensor 100 and is, for example, a circuit pattern.

### About Converter

The converter 200 includes the controller 210 and a connection part 220.

The connection part 220 is connected to the individual information communication line 150 and the analog signal line 140 of the analog sensor 100. The connection part 220 is a structure complementary to the detachment unit 221. For example, the connection part 220 is a sensor connection terminal and the detachment unit 221 is a round terminal or a pin terminal and thus the connection part 220 and the detachment unit 221 are complementary structures. When the analog sensor 100 is detached, the analog sensor 100 is separated at the detachment unit 221.

The controller 210 controls the whole converter 200. The controller 210 includes an individual information function unit 211 and an arithmetic section 212. The controller 210 is enabled using an electric circuit, such as a central processing unit (CPU) or a micro processing unit (MPU), or an integrated circuit, such as an application specific integrated circuit (ASIC) or a field programmable gate array (FPGA).

The individual information function unit 211 executes a process on individual information. For example, when the converter 200 is started, the individual information function unit 211 reads the serial number contained in the individual information in the digital storage element 120 via the individual information communication line 150 of the analog sensor 100. The individual information function unit 211 identifies the analog sensor 100 that is connected.

For example, when the converter 200 is started, the individual information function unit 211 reads the correction value contained in the individual information in the digital storage element 120 via the individual information communication line 150 of the analog sensor 100. The individual information function unit 211 then initializes the correction value of the arithmetic section 212.

For example, the individual information function unit 211 reads the correction history contained in the individual information in the digital storage element 120 via the individual information communication line 150 of the analog sensor 100. The individual information function unit 211 then executes a deterioration diagnosis on the analog sensor 100. The individual information function unit 211 diagnoses a degree of deterioration of the analog sensor 100 from the correction values in the past, outputs the result of the diagnosis to the individual information in the digital storage element 120 via the individual information communication line 150, and stores the result as the deterioration diagnosis information.

For example, the individual information function unit 211 reads the deterioration diagnosis information over a life cycle contained in the individual information via the individual information communication line 150 of the analog sensor 100. The individual information function unit 211 analyzes deterioration diagnosis information and executes a process of predicting deterioration from trend values in the past for the next maintenance timing, time of replacement, and the like.

For example, the individual information function unit 211 executes a correction on the analog sensor 100, outputs the result of the correction to the individual information in the digital storage element 120 via the individual information communication line 150 of the analog sensor 100, and stores the result as the correction value.

The arithmetic section 212 computes a measured value. For example, the arithmetic section 212 computes a measured value using the electric signal that is acquired via the analog signal line 140 of the analog sensor 100 and the correction values.

### Flow of Process performed by Converter 200

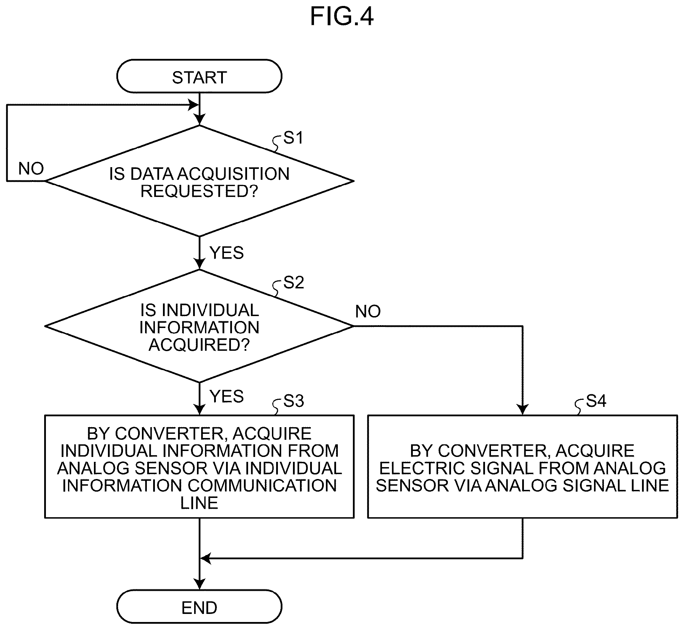

Using FIG. 4, an example of a process procedure taken by the converter 200 according to the first embodiment will be described next. FIG. 4 is a flowchart illustrating an example of a flow of acquisition of information from the analog sensor 100 according to the first embodiment. Note that it is possible to execute the steps in the flowchart illustrated in FIG. 4 in a different order, and there may be processing to be added or processing to be omitted.

The converter 200 makes a request to acquire data to the analog sensor 100 (Yes at S1). For example, before measuring a subject, the converter 200 requests the analog sensor 100 to acquire data for a correction value and an electric signal. Specifically, when the converter 200 is started or is connected to the analog sensor 100, the converter 200 requests the analog sensor 100 to acquire data. Note that, when the converter 200 does not request data acquisition from the analog sensor 100, the converter 200 repeats the process until the converter 200 makes the request (NO at S1).

When the data acquisition request of the converter 200 is a request to acquire individual information (YES at S2), the converter 200 acquires the individual information from the analog sensor 100 via the individual information communication line 150 (S3). For example, the individual information function unit 211 of the converter 200 accesses the individual information contained in the digital storage element 120 via the individual information communication line 150 of the analog sensor 100. The individual information function unit 211 then acquires the individual information containing the correction value, the deterioration diagnosis information, the serial number, etc.

On the other hand, when the data acquisition request of the converter 200 is a request not to acquire individual information but to acquire a measured value (NO at S2), the converter 200 acquires an electric signal from the analog sensor 100 via the analog signal line 140 (S4). For example, the arithmetic section 212 of the converter 200 acquires an electric signal corresponding to a measured value obtained by the analog sensor 100 by performing measurement from the sensor unit 130 via the analog signal line 140. For example, the individual information function unit 211 initializes the correction value in the arithmetic section 212 based on the acquired correction value. The arithmetic section 212 calculates a measured value on the subject using the acquired electric signal and the initialized correction value.

The process of acquiring individual information and the process of acquiring an electric signal that are described above may be executed asynchronously or in parallel. In an example of acquisition timing, an electric signal is acquired constantly at intervals of, for example, 100 ms and individual information is acquired at an event, such as a start or a correction.

### Effects

As described above, the analog sensor 100 stores the individual information on the analog sensor 100. The converter 200 acquires the individual information on the analog sensor 100 from the analog sensor 100. Accordingly, the conventional analog sensor 20 and the analog sensor 100 do not have the restriction on the correspondence relationship that the conventional converter 10 and the conventional analog sensor 20 have.

Eliminating the restriction on the correspondence relationship between the converter 200 and the analog sensor 100 enables the user to detach the analog sensor 100 from the converter 200 and perform a correction operation, a deterioration diagnosis, or the like, on the analog sensor 100 using the converter 200 that is set on a safe site other than the field site. Accordingly, the work of the user is significantly reduced.

The user is also able to prepare the analog sensor 100 on which a correction is executed previously as a spare item. When an unexpected failure, or the like, occurs, the user is able to perform measurement according to correct individual information by only attaching this analog sensor 100 to the converter 200. Accordingly, cumbersome operations, such as re-correction or manual transfer of individual information, that are performed on the site of measurement in order to deal with the unexpected failure, or the like, are unnecessary and it is possible to prevent occurrence of a human error.

The analog sensor 100 is able to accumulate the individual information on the analog sensor 100 accurately over the life cycle. Accordingly, it is unnecessary for the user to introduce an external system, or the like, and this leads to cost reduction.

The analog sensor 100 is able to accumulate the deterioration diagnosis information, and the like, contained in the individual information on the analog sensor 100 over the life cycle steadily. Accordingly, the user is able to know more accurate time of maintenance, and the like.

The analog sensor 100 stores the individual information. Accordingly, the user, a manufacturer, and the like, are able to keep monitoring the operational status of each analog sensor 100. A mix-up of the analog sensors 100 does not occur and thus the manufacturer is able to provide users with an automated service of inventory control on spare parts that are usable assuredly.

The analog sensor 100 is able to store the individual information. This enables the converter 200 to identify the analog sensor 100 individually. Utilizing this function makes it possible to add, as the individual information function, a function that the converter 200 requests license activation to the analog sensor 100. Accordingly, the manufacturer is able to take a sales strategy giving preferential treatment to the analog sensors 100 of the manufacturer.

On the other hand, a digital sensor is usable even without the conventional converter 200 and it is possible to perform a maintenance operation, such as a correction, on a safe site. The digital sensor however includes an integrated circuit that executes sophisticated digital processing, such as an arithmetic section that computes a measured value and a digital communication unit that enables digital communication with the outside, and thus is expensive. The digital sensor performs a correction without the converter 200 and therefore it is necessary to prepare an environment and a facility for executing a correction. For this reason, an initial investment in transfer from the analog sensors 20 to the digital sensors is expensive, which is an obstacle in the transfer. Furthermore, because the digital sensor includes an integrated circuit inside, it is necessary to use the digital sensor in consideration of electric noise, etc.

Thus, the analog sensor 100 of the disclosure stores the individual information inside and provides the individual information to the converter 200 via the dedicated signal line. As a result, the analog sensor 100 eliminates the above-described restriction between the conventional converter 10 and the conventional analog sensor 20 and enables an operation, such as maintenance, on a safe site. Accordingly, it is unnecessary for the user to make an initial investment in a facility, and the like, associated with transfer to expensive digital sensors and introduction of digital sensors.

Also as for the manufacturing cost of the single analog sensor 100, a significant increase from the conventional analog sensor 20 is not caused and the single analog sensor 100 is enabled. Furthermore, the analog sensor 100 need not take electric noise, or the like, into consideration and is usable widely in the same environment as that of the conventional analog sensor 20.

### Second Embodiment

The analog sensor 100 of the disclosure is also able to include a detachment unit 110 that is detachable from the analog signal line 140 and the individual information communication line 150 in the state where the analog signal line 140 and the individual information communication line 150 are being connected to the converter 200. Thus, in a second embodiment, an example where the detachment unit 110 is set in the analog sensor 100 will be described.

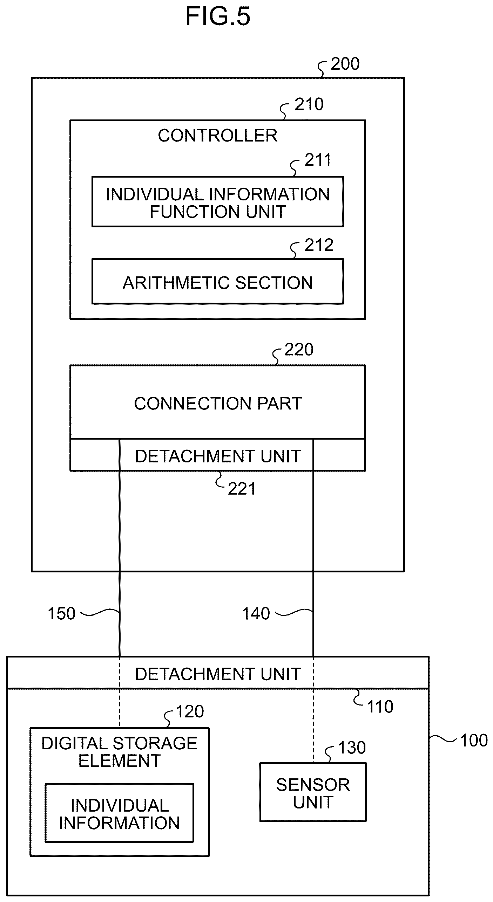

FIG. 5 is a diagram illustrating an example of a configuration of an analog sensor system using the analog sensor 100 and the converter 200 according to the second embodiment. As illustrated in FIG. 5, the analog sensor 100 according to the second embodiment is different from the analog sensor 100 according to the first embodiment in including a detachment unit 110. The analog sensor system using the analog sensor 100 and the converter 200 according to the second embodiment is common with the analog sensor system according to the first embodiment in components. A different configuration of the analog sensor system according to the second embodiment from that of the analog sensor system according to the first embodiment will be described below. Note that description of the same configuration and the same process as those of the first embodiment will be omitted.

The analog sensor 100 according to the second embodiment includes the detachment unit 110. This enables a user to detach the detachment unit 110, the digital storage element 120, and the sensor unit 130 that form the analog sensor 100 easily from the analog sensor system.

Among the components of the analog sensor 100, the digital storage element 120 and the sensor unit 130 are main components of the analog sensor 100. The digital storage element 120 that is a main component of the analog sensor 100 of the second embodiment is connected by electric wiring in any mode compatible with the individual information communication line 150 from the detachment unit 110. The sensor unit 130 that is the main component of the analog sensor 100 of the second embodiment is connected by electric wiring in any mode compatible with the analog signal line 140 from the detachment unit 110.

As illustrated in FIG. 5, the analog sensor 100 is provided with the detachment unit 110 enabling the main components of the analog sensor 100 to be detached from the individual information communication line 150 and the analog signal line 140 in the state where the individual information communication line 150 and the analog signal line 140 are being connected to the converter 200.

The detachment unit 110 detaches the main components of the analog sensor 100 from the cables. For example, the detachment unit 110 is a pin-connector male-female structure like a VarioPin and is a structure that is detachable without any tool. Thus, in the state where the analog signal line 140 and the individual information communication line 150 are being connected to the converter 200, the user is able to detach the main components (the digital storage element 120 and the sensor unit 130) of the analog sensor 100 together with the detachment unit 110 from the analog signal line 140 and the individual information communication line 150.

In other words, the user is able to carry the detachment unit 110 and the main components of the analog sensor 100 without separating them. When the main components of the analog sensor 100 are detached together with the detachment unit 110, only the analog signal line 140 and the individual information communication line 150 are being connected to the converter 200.

The detachment unit 221 of the converter 200 is configured using a screw terminal and it is difficult to detach the analog sensor 100 and thus there has been room for improvement. Providing the analog sensor 100 with the detachment unit 110 as described above enables the user to detach the main components of the analog sensor 100 easily, which increases workability.

### Third Embodiment

In the second embodiment, the example where the analog sensor 100 includes the detachment unit 110 has been described; however, the configuration is not limited to this and it is possible to set the digital storage element 120 of the analog sensor 100 of the first embodiment in the detachment unit 110. Thus, in a third embodiment, the configuration in which the digital storage element 120 is set in the detachment unit 110 will be described.

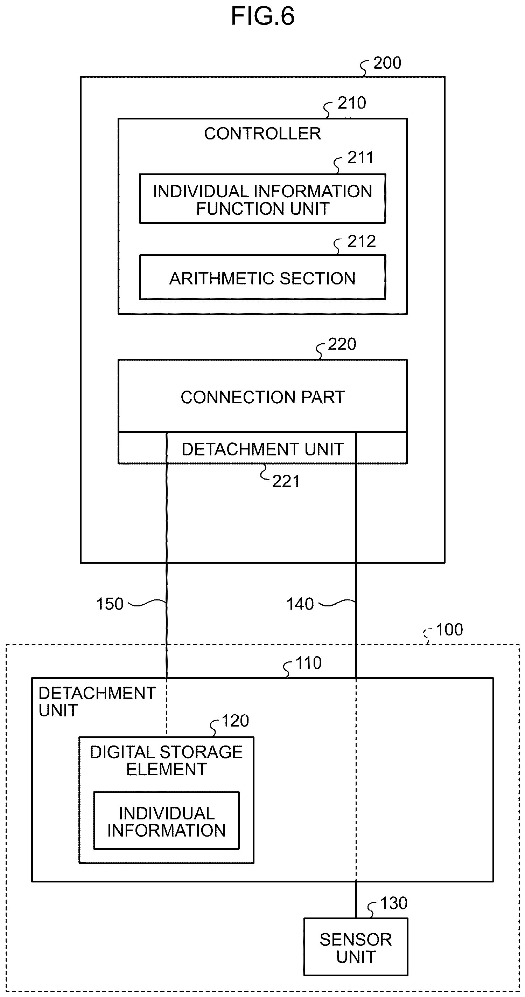

FIG. 6 is a diagram illustrating an example of a configuration of an analog sensor system using the analog sensor 100 and the converter 200 according to the third embodiment. The analog sensor system according to the third embodiment will be described. As illustrated in FIG. 6, the converter 200 has the same configuration as that described in the first embodiment. On the other hand, the analog sensor 100 is configured with the detachment unit 110 and the sensor unit 130 being separated from each other and the detachment unit 110 and the sensor unit 130 are connected with the analog signal line 140. The detachment unit 110 is set in the middle of the analog signal line 140 connecting the converter 200 and the sensor unit 130. Note that a configuration and a process similar to those of the first and the second embodiments will be omitted.

The digital storage element 120 that is a main component of the analog sensor 100 according to the third embodiment is connected by electric wiring in any mode compatible with the individual information communication line 150 inside the detachment unit 110. The sensor unit 130 that is a main component of the analog sensor 100 according to the third embodiment is connected to electric wiring in any mode compatible with the analog signal line 140 in the detachment unit 110 from the detachment unit 110 via the analog signal line 140. Note that the main components of the analog sensor 100 are fixed via the detachment unit 110.

The detachment unit 110 of the analog sensor 100 includes the digital storage element 120 that is connected with the electric wiring in any mode compatible with the individual information communication line 150 and the electric wiring in any mode corresponding to the analog signal line 140.

This configuration enables the user to detach the detachment unit 110 and the main components of the analog sensor 100 from the analog signal line 140 and the individual information communication line 150 in the state where the analog signal line 140 and the individual information communication line 150 are being connected to the converter 200.

In other words, the user is able to carry the main components of the analog sensor 100 together with the detachment unit 110. When the main components of the analog sensor 100 are detached together with the detachment unit 110, only the analog signal line 140 and the individual information communication line 150 are being connected to the converter 200.

In the first embodiment and the second embodiment, adding the digital storage element 120 to the detector lifts the restriction on the correspondence relationship between the converter 200 and the analog sensor 100. Changing the structure of an existing detector is difficult in some cases because of securing the performance of the analog sensor, or the like.

On the other hand, in the third embodiment, adding the digital storage element 120 not to the detector but to the detachment unit 110 lifts the restriction on the correspondence relationship between the converter 200 and the analog sensor 100. For this reason, even when it is not enabled by the first embodiment or the second embodiment, the third embodiment makes it possible to lift the restriction on the correspondence relationship between the conventional converter 10 and the conventional analog sensor 20.

### Fourth Embodiment

In the third embodiment, the example where the digital storage element 120 is set in the detachment unit 110 of the analog sensor 100 has been described; however, the configuration is not limited to this and it is possible to set a non-detachment unit 160 between the detachment unit 110 and the sensor unit 130 that form the analog sensor 100. Thus, in a fourth embodiment, a configuration in which the non-detachment unit 160 is set in the analog sensor 100 will be described.

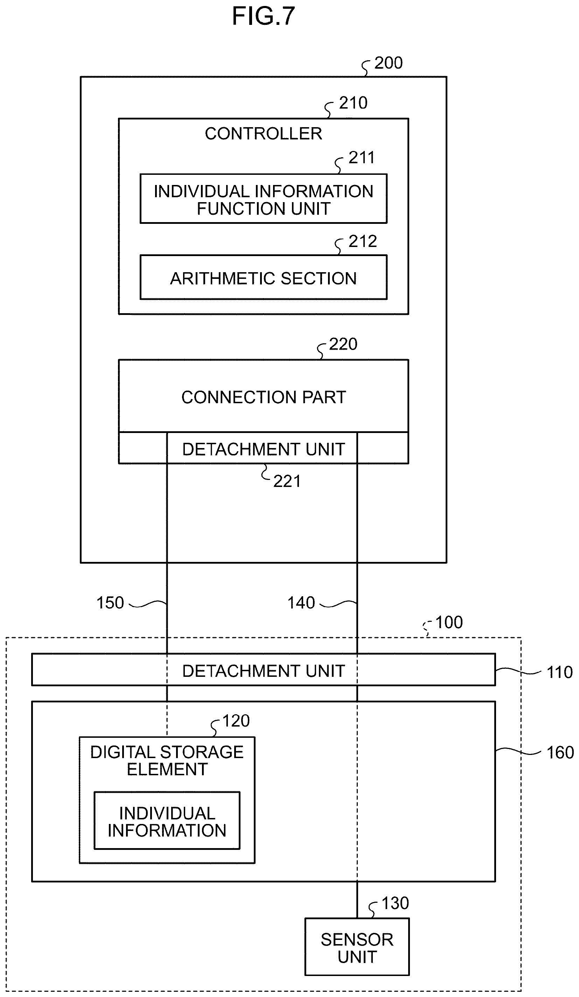

FIG. 7 is a diagram illustrating an example of a configuration of an analog sensor system using the analog sensor 100 and the converter 200 according to the fourth embodiment. The analog sensor system according to the fourth embodiment will be described. As illustrated in FIG. 7, the converter 200 has the same configuration as that described in the first embodiment. On the other hand, the analog sensor 100 is configured with the detachment unit 110, the non-detachment unit 160, and the sensor unit 130 being separated from each other. The analog sensor 100 of the fourth embodiment is different from the analog sensor 100 of the third embodiment in the configuration of the detachment unit 110 and in including the non-detachment unit 160. Note that description of the same configuration and the same process as those of the first to third embodiments will be omitted.

The digital storage element 120 that is a main component of the analog sensor 100 is set in the non-detachment unit 160. As illustrated in FIG. 7, the digital storage element 120 is connected by electric wiring in any mode compatible with the individual information communication line 150 inside the detachment unit 110 from the detachment unit 110, the individual information communication line 150, and electric wiring in any mode compatible with the individual information communication line 150 inside the non-detachment unit 160.

As illustrated in FIG. 7, the sensor unit 130 that is the main component of the analog sensor 100 is connected by electric wiring in any mode compatible with the analog signal line 140 inside the detachment unit 110 from the detachment unit 110, the analog signal line 140, electric wiring in any mode compatible with the analog signal line 140 inside the non-detachment unit 160, and the analog signal line 140.

The detachment unit 110 has a structure that is detached from the individual information communication line 150 and the analog signal line 140. Furthermore, the inside of the detachment unit 110 has electric wiring in any mode compatible with each of the individual information communication line 150 and the analog signal line 140. Attaching the detachment unit 110 to the individual information communication line 150 and the analog signal line 140 that are connected to the converter 200 connects the analog sensor 100.

The non-detachment unit 160 includes the digital storage element 120 that is connected by the electric wiring in any mode corresponding to the individual information communication line 150 and electric wiring in any mode compatible with the analog signal line 140. The non-detachment unit 160 can be included in any part where the non-detachment unit 160 is detachable together with the detachment unit 110. The non-detachment unit 160 is connected to the detachment unit 110 via the individual information communication line 150 and the analog signal line 140. The non-detachment unit 160 is connected to the sensor unit 130 via the analog signal line 140. The non-detachment unit 160 is connected to the individual information communication line 150 from the detachment unit 110 and is connected to the digital storage element 120 by electric wiring in any mode compatible with the individual information communication line 150. Note that the non-detachment unit 160 may include only the digital storage element 120 that is connected by electric wiring in any mode corresponding to the individual information communication line 150.

The main components of the analog sensor 100 are fixed to the detachment unit 110 and the non-detachment unit 160. Note that, when the non-detachment unit 160 includes only the digital storage element 120, the main component of the analog sensor 100 is fixed to the detachment unit 110.

This configuration enables a user to detach the main component of the analog sensor 100 together with the detachment unit 110 from the analog signal line 140 and the individual information communication line 150 in the state where the analog signal line 140 and the individual information communication line 150 are being connected to the converter 200.

In other words, the user is able to carry the detachment unit 110 and the main component of the analog sensor 100. When the main component of the analog sensor 100 is detached together with the detachment unit 110, only the analog signal line 140 and the individual information communication line 150 are being connected to the converter 200.

In the fourth embodiment, the digital storage element 120 is set in the non-detachment unit 160. Thus, in the analog sensor 100, it is unnecessary to make a structural change in the detector and the detachment unit 110 of the analog sensor 100, which eliminates the above-described restriction between the conventional converter 10 and the conventional analog sensor 20.

The functions described in the above-described embodiments, and the like, are an example only and they can be changed freely. The flow of the process can be also changed appropriately within a range without inconsistency.

### System

The process procedures, the control procedure, the specific names, and the information including various types of data and parameters that are presented in the description above and the drawings are changeable freely except as otherwise provided.

Each of the components of each of the devices illustrated in the drawings is of functional ideas and need not necessarily be configured physically as illustrated in the drawings. In other words, specific modes of distribution and integration of each device are not limited to those illustrated in the drawings. In other words, all or part of the devices can be configured by being distributed or integrated functionally or physically in any unit according to various types of load, usage, etc.

Furthermore, all or any part of each processing function that is implemented in each device can be implemented by a CPU and using a program that is analyzed and executed by the CPU or may be implemented as hardware using a wired logic.

It is also possible to provide the analog sensor 100 with a plurality of the digital storage elements 120 as required.

According to the disclosure, an analog sensor and an analog sensor system that are highly useful are provided.

## Claims

1. An analog sensor (100) that is connected to a converter (200) that computes a measured value, the analog sensor (100) comprising:
a sensor unit (130) that measures a physical quantity and that converts the physical quantity into an electric signal that is used to compute the measured value;
a memory (120) that stores individual information that is information unique to the analog sensor (100);
a first signal line (150) that is used to input and output the individual information between the converter (200) and the analog sensor (100); and
a second signal line (140) that is used to input and output the electric signal between the converter (200) and the analog sensor (100).

2. The analog sensor (100) according to claim 1, the analog sensor further includes a detachment unit (110) having a structure that is detachable together with the sensor unit (130) from the first signal line (150) and the second signal line (140),
wherein
the detachment unit has the memory (120),
the first signal line (150) connects the converter (200) and the memory (120) in the detachment unit (110), and
the second signal line (140) connects the converter (200) and the sensor unit (130) via electric wiring laid in the detachment unit (110).

3. The analog sensor (100) according to claim 1, the analog sensor further includes:
a non-detachment unit (160) having the memory (120); and
a detachment unit (110) having a structure that is detachable together with the non-detachable unit (160) and the sensor unit (130) from the first signal line (150) and the second signal line (140),
wherein
the first signal line (150) connects the converter (200) and the memory (120) in the non-detachment unit (160) via electric wiring laid in the detachment unit (110), and
the second signal line (140) connects the converter (200) and the sensor unit (130) via electric wiring laid in the detachment unit (110) and electric wiring laid in the non-detachment unit (160).

4. An analog sensor system comprising a converter (200) and an analog sensor (100), wherein
the converter (200) includes an arithmetic section (212) that computes a measured value using an electric signal of the analog sensor (100), and
the analog sensor (100) includes;
a sensor unit (130) that measures a physical quantity and that converts the physical quantity into an electric signal that is used to compute the measured value;
a memory (120) that stores individual information that is information unique to the analog sensor (100);
a first signal line (150) that is used to input and output the individual information between the converter (200) and the analog sensor (100); and
the second signal line (140) that is used to input and output the electric signal between the converter (200) and the analog sensor (100).

5. The analog sensor system according to claim 4, the converter (200) further includes an individual information function unit (211) that executes a process via the individual information, wherein
the individual information function unit (211) acquires the individual information from the analog sensor (100) using the first signal line (150), and
the arithmetic section (212) acquires the electric signal from the analog sensor (100) using the second signal line (140).

6. The analog sensor system according to claim 5, wherein the individual information function unit (211) acquires a correction value contained in the individual information from the first signal line (150) and initializes a correction value used by the arithmetic section (212) to calculate the measured value.

7. The analog sensor system according to claim 5 or 6, wherein the individual information function unit (211) acquires a correction history contained in the individual information from the first signal line (150) and diagnoses deterioration of the analog sensor using the correction history.

8. The analog sensor system according to any one of claim 5 to 7, wherein the individual information function unit (211) calculates a correction value by performing a correction on the analog sensor (100) and writes the calculated correction value in the memory (120) of the analog sensor (100) via the first signal line (150).
